# EUROPÄISCHE PATENTSCHRIFT

(11) **EP 2 984 674 B1**
(45) Veröffentlichungstag und Bekanntmachung des Hinweises auf die Patenterteilung: **06.06.2018**
(21) Anmeldenummer: 14718509.4
(22) Anmeldetag: 07.04.2014
(51) Int. Cl.: H01J 37/34, C23C 14/34

(54) **SPUTTERTARGET MIT ERHÖHTER LEISTUNGSVERTRÄGLICHKEIT**
SPUTTERING TARGET HAVING INCREASED POWER COMPATIBILITY
CIBLE DE PULVÉRISATION CATHODIQUE À COMPATIBILITÉ DE PUISSANCE ACCRUE

(30) Priorität: 08.04.2013 US 201361809524 P
(43) Veröffentlichungstag der Anmeldung: 17.02.2016
(73) Patentinhaber: Oerlikon Surface Solutions AG, Pfäffikon, 8808 Pfäffikon SZ (CH)
(72) Erfinder: KRASSNITZER, Siegfried, A-6800 Feldkirch (AT); HAGMANN, Juerg, CH-9468 Sax (CH); KERSCHBAUMER, Joerg, A-6800 Feldkirch (AT)
(74) Vertreter: Misselhorn, Hein-Martin
(86) Internationale Anmeldenummer: PCT/EP2014/000927
(87) Internationale Veröffentlichungsnummer: WO 2014/166620

(56) Entgegenhaltungen:
- EP-A1- 0 512 456
- EP-A1- 1 106 715
- DE-A1- 19 535 894
- "Hochwärmeleitende Karbonfolien Serie KU-CB1200", INTERNET CITATION, 30. November 2010 (2010-11-30), Seite 1, XP002697228, Gefunden im Internet: URL:http://www.heatmanagement.com/local/me dia/hmproducts/ku-cb1200-50/ku-cb1200_date nblatt.pdf [gefunden am 2013-05-16]
- Kaneka Corporation: "Graphinity", , 2010, XP002728571, Gefunden im Internet: URL:http://www.elecdiv.kaneka.co.jp/englis h/graphite/index.html [gefunden am 2014-08-14]

## Beschreibung

Die vorliegende Erfindung betrifft ein Plattenzentrierungssystem umfassend eine Platte mit Halterung, beim dem die Platte in der Halterung sowohl bei Raum- als auch bei höheren Temperaturen unabhängig von der Wärmeausdehnung der Platte und der Halterung zentriert ist, und die Platte sich in der Halterung bei höheren Temperaturen frei ausdehnen kann. Insbesondere betrifft die vorliegende Erfindung ein Target mit rahmenförmiger Targetfassung, das in einer Beschichtungsquelle für Hochleistungsimpulsmagnetronsputtering des Targets sehr gut geeignet ist.

### Stand der Technik

Hohe Leistungsdichten sind notwendig, um Sputterprozesse wirtschaftlich zu betreiben. Dabei ist aber die Kühlung des Sputtertargets sehr entscheidend.

Sputtertargets werden heutzutage üblicherweise entweder direkt oder indirekt gekühlt.

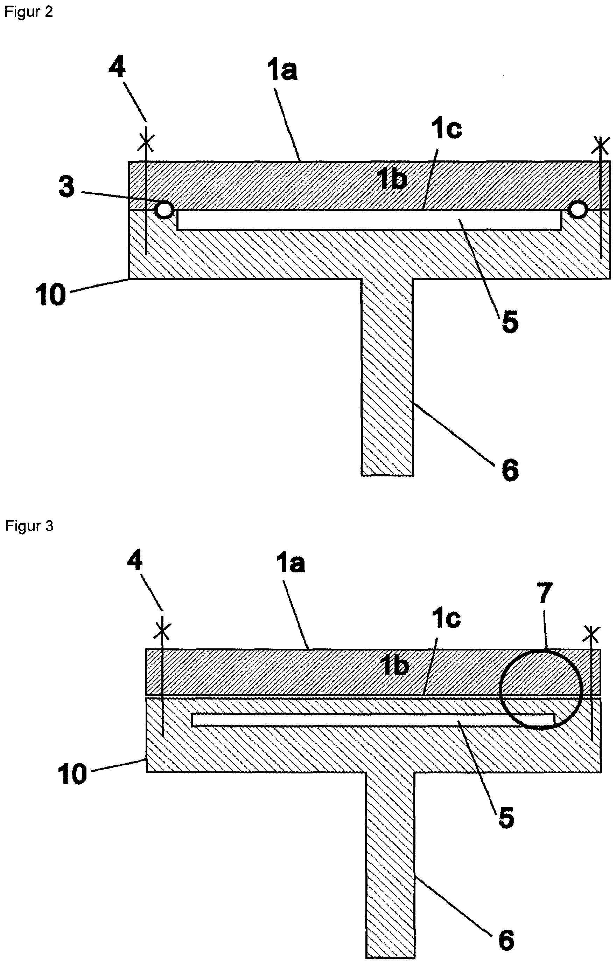

Ein direkt gekühltes Target ist beispielsweise in der Zeichnung in Figur 2 schematisch dargestellt: Die für das Sputtern an der Targetoberfläche 1a umgesetzte Leistung wird in Abhängigkeit von der Wärmeleitfähigkeit des Targetmaterials 1b durch Wärmeleitung zur Targetrückseite 1c geleitet. Eine Kühlungsflüssigkeit (üblicherweise Wasser) fliesst durch den Kühlungsflüssigkeitskanal 5 (üblicherweise Wasserkanal) in einem Sputterquellengrundkörper 10 und führt den Wärmefluss entsprechend den Strömungsverhältnissen ab. Um das Target 1 fix an den Wasserkanal 5 zu binden, werden normalerweise Schrauben 4 verwendet, die das Target 1 und den Sputterquellengrundkörper 10 durchdringen. Ausserdem ist es auch nötig, eine Dichtung 3 anzubringen, um zu vermeiden, dass Wasser in die Vakuumkammer einfliesst. Weitere dem Fachmann bekannte Komponenten einer Sputtertarget-Kühlungsvorrichtung dieser Art sind in der Figur 2 nicht dargestellt.

Ein indirekt gekühltes Target ist beispielsweise in der Zeichnung in Figur 3 dargestellt. In diesem Fall ist der Kühlungsflüssigkeitskanal 5 geschlossen, wobei eine sogenannte geschlossene Kühlplatte gebildet wird. Das Target 1 wird an der geschlossenen Kühlplatte derart befestigt (bspw. geschraubt oder geklemmt), dass die Rückseite 1c des Targets 1 mit der Kühloberfläche im Kontakt gebracht wird, und durch Andrücken der Targetrückseite 1 c auf die Kühloberfläche ein Wärmetransfer vom Target zur Kühlungsflüssigkeit ermöglicht bzw. begünstigt wird. Weitere dem Fachmann bekannte Komponenten einer Sputtertarget-Kühlungsplattevorrichtung dieser Art sind in der Figur 2 nicht dargestellt.

Je nach Kühlmethode oder extremen Leistungsdichten kann es zu einer hohen Temperatur des Targets kommen und die mechanische Festigkeit des Targetmaterials versagen.

Beispielsweise im Fall eines Targets aus Aluminium, das auf eine Kühlplatte, wie in Figur 3, mit Schrauben am Rand der Kühlplatte fixiert und auf die feste Kühloberfläche gepresst wird. Es kann passieren, dass bei Erwärmung durch Sputterbetrieb in einer Sputtertarget-Kühlungsplattevorrichtung, wie in Figur 3 dargestellt, das Target sich ausdehnt, bis es zu Verspannungen und mechanischen Verwerfungen durch Einspannung mittels der Schrauben kommt, die in einer Verschlechterung des Wärmeübergangs zur Kühlplatte resultieren, welche zur Zerstörung des Target führen kann. Unter Berücksichtigung dieser Randbedingungen muss die Leistungsdichte an einem Sputtertarget, beispielsweise aus Aluminium, auf Werte unter 10W/cm², womöglich unter 5W/cm² limitiert werden.

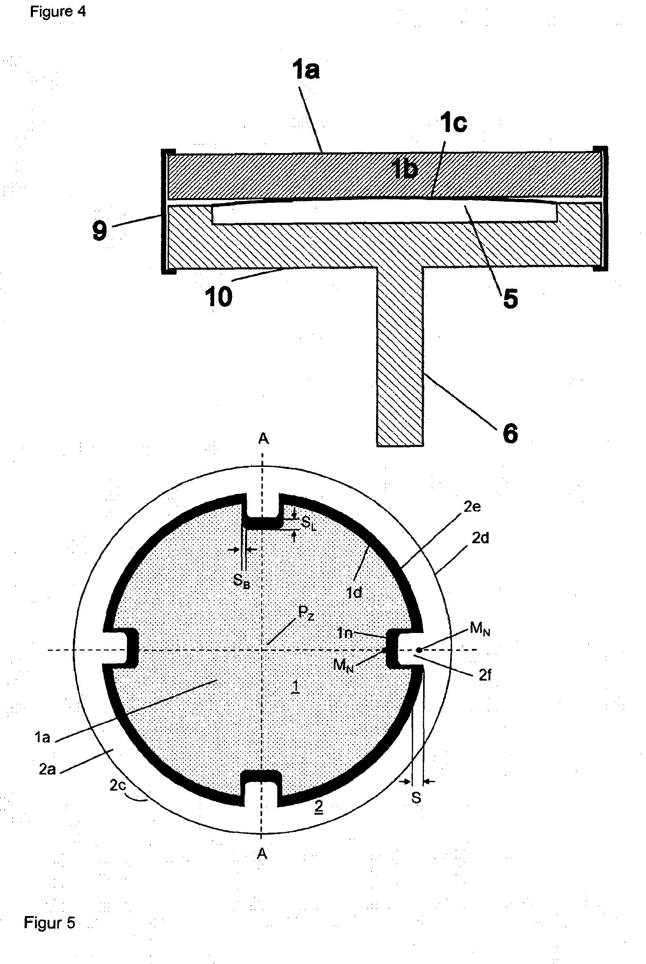

Eine weitere wichtige Methode der Targeteinspannung und Kühlung ist die indirekte Kühlung mit beweglicher Membrane, die in Figur 4 angegeben ist. Das Target wird auf dem Sputterquellengrundkörper 10 durch geeignete Mittel 9 fixiert (bspw. durch Klammern, Schrauben, Bajonette). Im Kühlkanal 5, welcher mit Kühlungsflüssigkeit (in der Regel Wasser) durchflossen ist, herrscht ein hydrostatischer Druck, welcher die bewegliche Membrane gleichförmig an die Targetrückseite 1c andrückt. Eine solche bewegliche Membrane kann beispielsweise eine Art Metallfolie sein. Deswegen werden solche Kühlungsplattevorrichtungen mit beweglicher Membrane auch Folienkühlplattevorrichtungen oder einfach Folienkühlplatten genannt.

Zwischen Membran und Targetrückseite ist eine reduzierte Wärmeübergangsfläche zu erwarten. Diese Übergangsfläche kann durch Einlage einer duktilen Einlegefolie aus z.B. Indium, Zinn, Graphit wesentlich verbessert werden. Beispielsweise kann eine extrem dünne selbstklebende Karbonfolie auf die Targetrückseite oder auf die Seite der Membrane, die im Kontakt mit der Targetrückseite sein soll, geklebt werden, wie in WO2013149692A1 beschrieben ist, um den Wärmeübergang optimal zu verbessern.

Ein Nachteil dieser Methode ist allerdings, dass das Target durch den hydrostatischen Druck auf Durchbiegung belastet ist. Die mechanische Festigkeit des Targets bei extrem hohen Leistungsdichten und erhöhten Temperaturen reicht oft nicht aus, um eine Verbiegung und folgliche Zerstörung des Targets zu verhindern. Insbesondere reicht sie nicht aus, wenn Bajonetten als Widerlager für die Einspannung und Fixierung des Targets auf dem Sputterquellenkörper verwendet werden. Beispielweise werden in der Regel pulvermetallurgisch hergestellte Targets aus Aluminium und Titan oder aus Aluminium und Chrom bei einer Temperatur über 200°C sehr weich und duktil. Infolgedessen werden solche Targets bei Temperaturen über 200 °C oft stark verbogen und zerstört.

In EP0512456 A1 wird eine Targetplatte mittels eines zentralen und/oder peripheren Bajonettverschlusses montiert bzw. demontiert. Dabei umfasst die Wandung der Prozesskammer eine Kühlplatte mit Kühlkanälen, welche gegenüber der eingesetzten Targetplatte mittels folienartiger Membranen verschlossen sind. Durch Druckbeaufschlagung des Kühlmediums wird der Bajonettverschluss über die erwähnten Membranen gespannt.

### Aufgabe der vorliegenden Erfindung

Es ist Aufgabe der vorliegenden Erfindung, eine Sputterquellenvorrichtung bereitzustellen, die die Verwendung einer Kühlplattenvorrichtung mit beweglicher Membrane ermöglicht, wobei das Target bei hohen Temperaturen durch die Wirkung des hydrostatischen Drucks im Kühlkanal der Kühlplattenvorrichtung nicht zerstört wird.

### Beschreibung der vorliegenden Erfindung

Die Aufgabe der vorliegenden Erfindung wird dadurch gelöst, indem eine Beschichtungsquelle mit einem Plattenzentrierungssystem, wie im Anspruch 1 beschrieben, bereitgestellt wird.

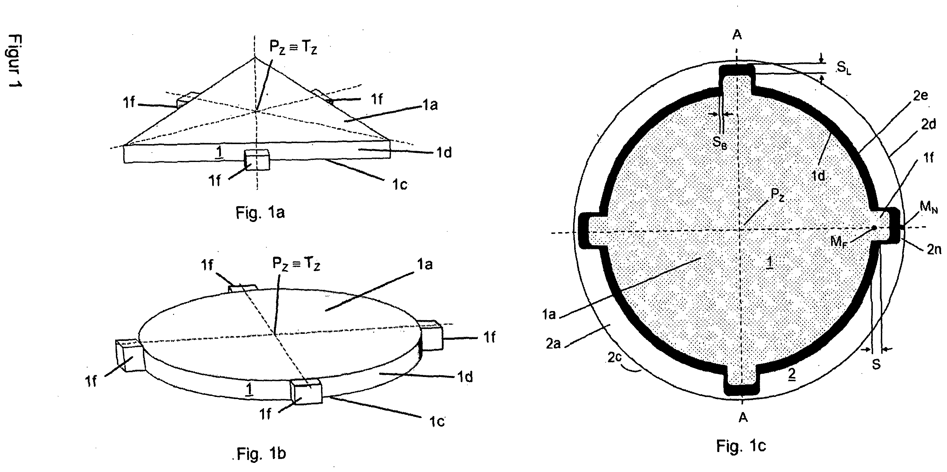

Das Plattenzentrierungssystem gemäss der vorliegenden Erfindung umfasst eine Platte mit Halterung, wie in Figur 1 schematisch gezeichnet, wobei die Platte 1 eine Frontseite 1a, eine Rückseite 1c und eine äussere Randfläche 1d, welche sich von der Frontseite bis zur Rückseite erstreckt, aufweist, und aus einem ersten Material 1b mit einem ersten thermischen Expansionskoeffizienten α1 angefertigt ist, die Halterung eine rahmenförmige Plattenfassung 2 mit einer Innenseite 2e zur Aufnahme der Platte umfasst, und aus einem zweiten Material mit einem zweiten thermischen Expansionskoeffizienten α2 angefertigt ist, dadurch gekennzeichnet, dass:
- bei Raumtemperatur der Umfang der Innenseite 2e der Plattenfassung grösser ist als der Umfang der Randfläche 1d der Platte 1 , wodurch bei zentrierter Position der Platte 1 in der Plattenfassung 2 ein Spalt mit einer definierten Spaltbreite S zwischen Randfläche der Platte und Innenseite der Plattenfassung vorliegt und
- die Randfläche, vorzugsweise die Randfläche 1d näher zur Unterseite 1c, eine oder mehrere Führungsausformungen 1f umfasst, welche sich über die Randfläche 1d hinaus nach aussen, vorzugsweise in einer Ebene im Wesentlichen parallel zur Rückseitenfläche 1d der Platte 1 , erstrecken und in korrespondierende Nuten 2n der Innenseite 2e der Plattenfassung 2 eingreifen und/oder die Randfläche 1d eine oder mehrere Nuten 1n umfasst, welche sich über die Randfläche 1d hinaus nach innen, vorzugsweise in einer Ebene im Wesentlichen parallel zur Rückseitenfläche der Platte, erstrecken und korrespondierende Führungsausformungen 2f der Innenseite 2e der Plattenfassung 2 in diese eingreifen,
- wobei das Plattenzentrierungssystem zumindest drei solcher ineinandergreifender Paare"Führungsausformung-Nut" umfasst und
   wobei für jedes Paar"Führungsausformung-Nut" die Breitenprofile in tangentialer Richtung zur Randfläche der Platte und die Längenprofile in perpendikularer Richtung zur Randfläche der Platte so aufeinander abgestimmt sind, dass bei Raumtemperatur das Spiel S_{B} in tangentialer Richtung kleiner als das Spiel S_{L} in perpendikularer Richtung und zugleich S_{L}≥ S ist, und wobei
- die Paare"Führungsausformung-Nut" derart verteilt sind, dass die Position M_{N} der Mitte der Breite einer Nut mit der Position M_{F} der Mitte der Breite der entsprechenden Führungsausformung bei jedem Paar"Führungsausformung-Nut" übereinstimmt, und diese Position derart ausgewählt ist, dass sie sich bei Raumtemperatur in einer axialen Richtung vom Plattenzentrum Pz befindet, die nach einer Wärmeausdehnung der Platte 1 oder der Platte 1 und der Plattenfassung 2 bei höheren Temperaturen unverändert in der gleichen axialen Richtung vom Plattenzentrum Pz ist, und sowohl bei Raumtemperatur als auch bei höheren Temperaturen, bei denen sich die Platte 1 oder die Platte 1 und die Plattenfassung 2 ausdehnen, die Platte 1 in der Plattenfassung 2 bis auf höchstens das Spiel S_{B} immer zentriert in der Plattenfassung verankert ist.

In einem Plattenzentrierungssystem gemäss der vorliegenden Erfindung ist der lineare Wärmeausdehnungskoeffizient des Plattenmaterials vorzugsweise grösser als der lineare Wärmeausdehnungskoeffizient des Halterungsmaterials oder zumindest gleich, d.h. α1≥α2, vorzugsweise α1>α2.

Eine besonders bevorzugte Ausführungsform der vorliegenden Erfindung betrifft ein System "Platte-Halterung", welches eine scheibenförmige Platte mit Halterung umfasst, wobei die Platte eine über weite Strecken ihres Umfangs kreisförmige Oberfläche mit einem äusseren Plattenrand aufweist und das Material der Platte einen ersten thermischen Expansionskoeffizienten, α1, besitzt und die Halterung eine über weite Strecken ihres Umfangs kreisförmige Öffnung aufweist, welche durch eine innere Halterungsberandung begrenzt ist und das Material der Halterung einen zweiten thermischen Expansionskoeffizienten, a2, besitzt, dadurch gekennzeichnet, dass
- bei Raumtemperatur der Umfang der Öffnung der Halterung grösser ist als der Umfang der Oberfläche der Platte, wodurch bei zentrierter Position der Platte in der Öffnung der Halterung ein Spalt mit einer definierten Spaltbreite S zwischen Plattenrand und innerer Halterungsberandung vorliegt und
- α2<α1 ist und
- der Plattenrand eine oder mehrere Ausformungen umfasst, welche sich vom Mittelpunkt der kreisförmigen Oberfläche aus gesehen in radialer Richtung,
   ausgehend von der Plattenrandoberfläche, über Ausformungslängen erstrecken und in korrespondierende Einformungen mit Einformungslängen der Halterungsberandung eingreifen und/oder der Plattenrand eine oder mehrere Einformungen umfasst, welche sich vom Plattenrand aus gesehen in Richtung Mittelpunkt der kreisförmigen Oberfläche über Einformungslängen erstrecken und korrespondierende Ausformungen mit Ausformungslängen der Halterungsberandung in diese eingreifen,
- wobei das System "Platte - Halterung" zumindest drei solcher ineinander eingreifender Einformungs - Ausformungspaare umfasst und
   wobei für die Einformungs-Ausformungspaare die Längen so gewählt sind, dass bei Raumtemperatur in radialer Richtung die Einformungen jeweils höchstens bis auf einen radialen Abstand d in die Ausformung eingreifen, dessen Grössenordnung derjenigen der Spaltbreite S entspricht,
   und wobei für die Einformungs-Ausformungspaare in tangentialer Richtung die Breitenprofile so aufeinander abgestimmt sind, dass die Einformung für die korrespondierende Ausformung als Führungsschiene wirken kann, deren Spiel sp (sp = S_{B}) in tangentialer Richtung kleiner als S ist
   und dadurch erreicht wird, dass sowohl bei Raumtemperatur als auch bei höheren Temperaturen, bei denen sich die Platte stärker ausdehnt als die Halterung, die sich ausdehnende Platte bis auf höchstens das Spiel sp immer zentriert in der Halterung verankert ist.

Der Ausdehnungskoeffizient oder Wärmeausdehnungskoeffizient ist ein Kennwert, der das Verhalten eines Stoffes bezüglich Veränderungen seiner Abmessungen bei Temperaturveränderungen beschreibt - deswegen oft auch thermischer Ausdehnungskoeffizient genannt. Der hierfür verantwortliche Effekt ist die Wärmeausdehnung. Die Wärmeausdehnung ist abhängig vom verwendeten Stoff, es handelt sich also um eine stoffspezifische Materialkonstante. Da die Wärmeausdehnung bei vielen Stoffen nicht gleichmäßig über alle Temperaturbereiche erfolgt, ist auch der Wärmeausdehnungskoeffizient selbst temperaturabhängig und wird deshalb für eine bestimmte Bezugstemperatur oder einen bestimmten Temperaturbereich angegeben.

Es wird zwischen dem thermischen Längenausdehnungskoeffizienten α (auch linearer Wärmeausdehnungskoeffizient) und dem thermischen Raumausdehnungskoeffizienten γ (auch räumlicher Ausdehnungskoeffizient oder Volumenausdehnungskoeffizient oder kubischer Ausdehnungskoeffizient) unterschieden.

Der Längenausdehnungskoeffizient α ist die Proportionalitätskonstante zwischen der Temperaturänderung dT und der relativen Längenänderung dL/L eines Festkörpers. Mit ihm wird demnach die relative Längenänderung bei einer Temperaturänderung beschrieben. Er ist eine stoffspezifische Grösse, der die Einheit K⁻¹ (pro Kelvin) hat und über die folgende Gleichung definiert ist: α=1/L•dl/dT, vereinfacht wäre die Gleichung L_{final} ≈ Lᵢₙᵢₜᵢₐₗ •(1+ α•ΔT).

Man könnte dann beispielsweise berechnen, welche Länge die Platte in einer bestimmten Richtung der Plattenoberfläche bei einer maximalen Einsatztemperatur hätte. In ähnlicher Weise könnte man die Dimensionen nach der Wärmeausdehnung der Halterung berechnen. Somit kann man berechnen, welche Spaltenbereiten zwischen der Platte und der Halterung nötig sind, um die freie Wärmeausdehnung der Platte in der Halterung bis zur maximalen Einsatztemperatur sicherzustellen.

Eine solche Berechnung kann beispielsweise unter der Annahme erfolgen, dass L_{1final} ≈ α₁ • L₁ᵢₙᵢₜᵢₐₗ • ΔT₁, wobei L_{1final} die Länge der Platte in einer bestimmten Richtung (im Fall einer scheibenförmigen Platte dann der Durchmesser) bei einer Temperatur T_{final} ist (beispielweise bei der maximalen Einsatztemperatur der Platte), α₁ der lineare Wärmeausdehnungskoeffizient der Platte bei dem Temperatureinsatzbereich ist, L₁ᵢₙᵢₜᵢₐₗ die Länge der Platte in der gleichen Richtung, aber einer Temperatur Tᵢₙᵢₜᵢₐₗ ist (beispielweise bei Raumtemperatur), und in ähnlicher Weise für die Berechnung der Dimensionen der Halterung bei T_{final}, aber unter Berücksichtigung der Form und Dimensionen der Halterung und des linearen Wärmeausdehnungskoeffizienten des Halterungsmaterials.

Vorzugsweise werden die Spaltbreiten zwischen der Platte und der Halterung so ausgewählt, dass die Platte sich innerhalb der Halterung bis zu einer Temperatur von mindestens 450 °C frei ausdehnen kann, vorzugsweise bis mindestens 500 °C, noch bevorzugter bis mindestens 650 °C.

Vorzugsweise werden die Einformungen und/oder Ausformungen in der Platte äquidistant voneinander verteilt.

Vorzugsweise ist die Halterung ringförmig oder umfasst einen ringförmigen Teil zur Aufnahme der Platte.

Gemäss einer weiteren bevorzugten Ausführungsform der vorliegenden Erfindung kann die Platte ein scheibenförmiges Target sein, welches sternförmig angebrachte Führungen umfasst, wobei je zwei Führungen eine gemeinsame Achse haben, die im Targetzentrum liegt, und die in entsprechende sternförmige Nuten der Halterung ragen, beispielsweise ist die Halterung ein Teil einer Kühlplatte-Vorrichtung. So wird das Target durch die erfindungsgemässe Target-Kühlplatte-Gestaltung temperaturunabhängig auf die Kühlplatte zentriert. Somit, im Fall der Verwendung eines Anodenrings um das Target herum, kann der Spalt zwischen Target und Anodenring konzentrisch bleiben bzw. erfindungsgemäss konzentrisch gehalten werden.

Dadurch werden Kurzschlüsse, die aufgrund eines unerwünschten Kontakts zwischen dem Target, die als Kathode betrieben wird, und dem Anodenring auftreten könnten, vermieden werden.

Auch dadurch bleibt die Auflagefläche zwischen Target und Targethalterung in der Kühlplattevorrichtung (bspw. zwischen Target und einem Targethaltering) konzentrisch und bei der Verwendung von Folienkühlplatten ergeben sich im Target gleichmässige Spannungen. Die Auflagefläche kann so minimiert werden. Anstatt Einformungen in der Kühlplatte vorzusehen, in welche Nasen vom Target hineinragen, ist es auch möglich, Einformungen im Target vorzusehen und den Aufnahmekörper der Kühlplatte-Vorrichtung, beispielweise den Targethaltering, mit nach innen ragenden Ausformungen auszuführen, welche in die Einformungen des Targets eingreifen, wie es in der Figur 5 gezeigt ist.

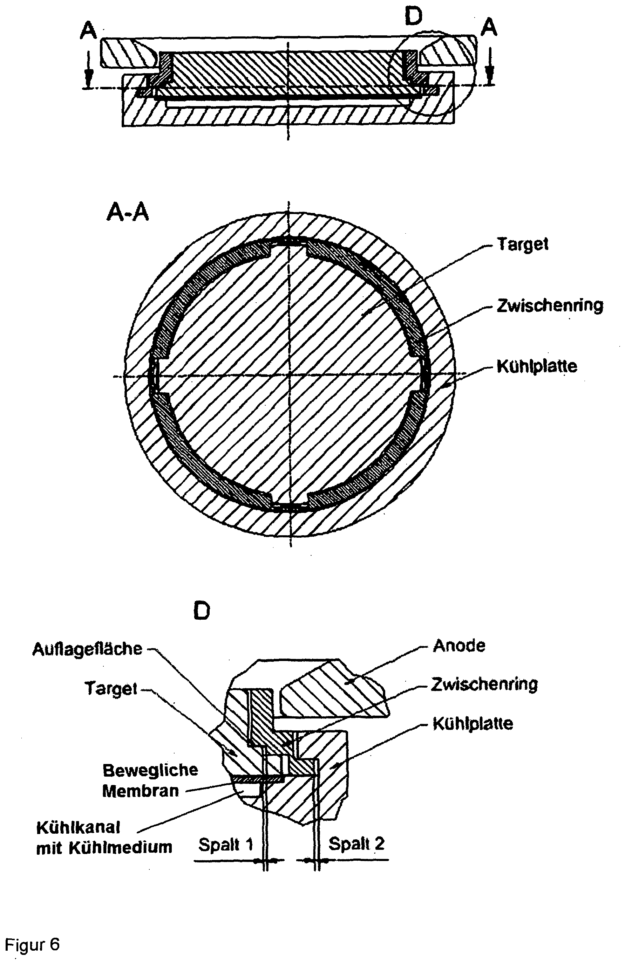

Ein besonderer Vorteil ergibt sich durch die Verwendung der vorliegenden Erfindung bei vorhandenen Kühlplatten, wobei ein zu geringer Spalt zwischen Target und Kühlplatte durch Einsatz eines Zwischenringes vergrössert werden kann. Wird das Target in einen Zwischenring und dieser dann auf die Kühlplatte montiert, so kann das gesamte Spiel (Spalt 1 und 2) zwischen Target und Kühlplatte und somit auch die eingebrachte Leistung vergrössert werden, wie es in der Figur 6 gezeigt wird.

Gemäss einer bevorzugten Ausführungsform der vorliegenden Erfindung ist das erfindungsgemässe Plattenzentrierungssystem ein Targetzentrierungssystem, bei dem die Platte 1 ein Target 1, die Halterung 2 ein Targetträger und die rahmenförmige Plattenfassung 2 eine rahmenförmige Targetfassung 2 zur Aufnahme des Targets 1 ist.

Vorzugsweise umfasst das Target gemäss der vorliegenden Erfindung eine Oberseite 1a, eine Unterseite 1c und eine Aussenseite 1d, wobei die Oberseite bzw. Frontseite des Targets eine erste Fläche definiert, die Unterseite bzw. Rückseite des Targets eine zweite Fläche definiert, und die Aussenseite bzw. die äussere Randfläche des Targets eine dritte Fläche definiert, welche sich von der Oberseite bis zur Unterseite erstreckt.

Die rahmenförmige Targetfassung 2 umfasst eine Innenseite 2e, welche mit Führungausformungen 2f und/oder Nuten 2n versehen ist, wobei jeweils die Führungsausformungen 2f sich über die Innenseite 2e hinaus nach innen erstrecken, und/oder die Nuten 2n sich über die Innenseite 2e hinaus nach aussen erstrecken.

Die Randfläche des Targets 1d ist entsprechend mit Führungsausformungen 1f und/oder Nuten 1n, vorzugsweise im Flächenbereich 1d näher zur Unterseite 1c versehen, wobei jeweils die Führungsausformungen 1f sich über die Randfläche 1d hinaus nach aussen vorzugsweise im Wesentlichen parallel zur zweiten Fläche 1c
erstrecken, und/oder die Nuten 1 n sich über die Randfläche 1d hinaus nach innen, vorzugsweise im Wesentlichen parallel zur zweiten Fläche 1c, erstrecken.

Zur Halterung des Targets sind wenigstens drei zueinander beabstandete Führungsausformungen und/oder Nuten jeweils im Target und in der Targetfassung vorhanden, damit jeweils die Führungsausformungen des Targets und/oder der Targetfassung in den entsprechenden Nuten der Targetfassung und/oder des Targets gefasst werden, wenn das Target auf die Targetfassung gebracht wird.

Die Führungsausformungen und/oder Nuten sind derart angefertigt, dass bei jedem Paar"Führungsausformung-Nut" die Breite und die Länge der Nut grösser als die Breite und die Länge der entsprechenden Führungsausformung sind.

Vorzugsweise haben alle Nuten die gleiche Form und die gleichen Dimensionen, und auch alle Führungsausformungen haben die gleiche Form und die gleichen Dimensionen.

Die Paare "Führungsausformung-Nut" sind derart verteilt, dass bei jedem Paar "Führungsausformung-Nut" die Position der Mitte der Breite der Nut mit der Position der Mitte der Breite der entsprechenden Führungsausformung übereinstimmt, und diese Position derart ausgewählt ist, dass sie sich bei Raumtemperatur in einer axialen Richtung vom Targetzentrum befindet, die nach einer Wärmeausdehnung des Targets und/oder der Targetfassung bei höheren Temperaturen in der gleichen axialen Richtung vom Targetzentrum unverändert bleibt.

Das Target kann eine beliebige Form aufweisen, beispielsweise kann es ein Rundes-, Rechteckiges-, Quadratisches-, Dreieckiges- oder Ovales-Sputtertarget sein.

Vorzugsweise ist die rahmenförmige Targetfassung aus einem speziellen zähen temperaturstabilen Stahl, welcher das Target, beispielsweise das Sputtertarget, schwimmend gelagert aufnimmt.

Masstoleranzen zwischen der rahmenförmigen Targetfassung und dem Sputtertarget ermöglichen eine Ausdehnung bei Temperaturerhöhung, ohne mechanischen Stress zu erzeugen.

Gemäss einer bevorzugten Ausführungsform der vorliegenden Erfindung ist das Target scheibenförmig.

Gemäss einer bevorzugten Ausführungsform der vorliegenden Erfindung ist die rahmenförmige Targetfassung ein Trägerring.

Ein Trägerring gemäss der vorliegenden Erfindung umfasst eine Oberseite 2a, eine Unterseite 2c, eine Innenseite 2e und eine Aussenseite 2d, wobei der Trägerring 2 zur mechanischen Befestigung des Targets an einem Sputterquellenkörper 10 dient und dabei die Innenseite 2e des Halterings zumindest teilweise die Aussenseite 1d des Targets umgibt.

Der Haltering umfasst in seiner Innenseite eine Vielzahl von mindestens drei Führungsnuten oder Führungszapfen, welche eine Zentrierungsfunktion erfüllen.

Entsprechend umfasst das Target in seiner Aussenseite radiale"Führungslaschen" oder "Führungsnuten", wodurch die Führung des Targets innerhalb des Trägerrings immer zentriert ist.

Die Vielzahl von zur Innenseite des Halterings inversen Ausnehmungen und/oder Verlängerungen passend zu den Führungszapfen und/oder Führungsnuten in der Aussenseite des Targets zentriert das Target innerhalb des Halterings, und das Spiel zwischen Aussenseite des Targets und Innenseite des Halterings ist so ausgewählt, dass Länge und Breiteänderungen in alle Richtungen stattfinden können.

Vorzugsweise wird das Target zuerst auf den Haltering gebracht, so dass die entsprechenden Paare "Führungszapfen-Ausnehmung" und/oder "Führungsnut-Verlängerung" verankert sind, und wenn nötig, eine Befestigungsklammer zur mechanischen Fixierung des Targets zum Haltering verwendet wird. Ein Federring kann beispielsweise als Befestigungsklammer in diesem Zusammenhang sehr gut geeignet sein.

Ein Haltering im Rahmen der vorliegenden Erfindung ist auch als ein"Zwischenring" angesehen und daher auch Zwischenring genannt, weil er zwischen dem Target und dem Sputterquellenkörper positioniert wird.

Vorzugsweise umfasst der Sputterquellenkörper eine Kühlungsvorrichtung zur Kühlung des Targets der Sorte geschlossene Kühlplatte mit beweglicher Membrane, so dass eine sehr gute Kühlwirkung bzw. ein guter Wärmeübergang über die bewegliche Membrane, welche die Targetrückseite andrückt, erreicht wird.

Wenn der Sputterquellenkörper eine Kühlplattevorrichtung mit beweglicher Membrane umfasst, ist es besonders von Vorteil, dass der Zwischenring aus einem sehr zähen, temperaturstabilen, unmagnetischen Stahl angefertigt wird. Auf diese Weise werden Verbiegungen des Zwischenrings und folglich des Targets vermieden, welche aufgrund des hydrostatischen Drucks, der die bewegliche Membrane gleichförmig an die Targetrückseite andrückt, geschehen können.

Beispielsweise ist der Haltering aus einem temperaturstabilen Stahl wie 1.3974 geschmiedet und lösungsgeglüht bei 1020°C für 1 Stunde.

Der Haltering umfasst vorzugsweise Bajonette in seiner Aussenseite, damit eine Montage bzw. Demontage eines bereits im Haltering aufgenommenen Targets gemäss der vorliegenden Erfindung in dem Sputterquellenkörper bzw. aus dem Sputterquellenkörper vereinfacht wird.

Zur Verbesserung des Wärmeübergangs und folglich zur Reduktion der Wärmebelastung und Steigerung der Leistungsdichte in einem Sputtertarget wird vorzugsweise an der Rückseite des Sputtertargets eine Karbonfolie, wie in WO2013149692A1 erwähnt, aufgeklebt.

Unter Verwendung eines Systems Target-Haltefassung-Sputterquellenkörper gemäss der vorliegenden Erfindung können Targets sowohl mit niedrigen Sputterleistungsdichten, beispielsweise im Bereich > 0 W/cm² bis < 50 W/cm², als auch mit sehr hohen Sputterleistungsdichten, beispielweise von 50 W/cm² bis 100 W/cm², betrieben werden.

Die Abstandstoleranz zwischen Aussenseite des Targets und Innenseite des Halterings muss gemäss der vorliegenden Erfindung so ausgewählt werden, dass die prozentuale Ausdehnung der unterschiedlichen Materialien, 1 und 2, mit unterschiedlichen Ausdehnungskoeffizienten, α1 und α2, berechnet wird. Beispielsweise könnte man für eine Kombination von einem Target aus einem typischen Beschichtungsmaterial, wie z.B. AI oder Ti, und einem Haltering aus Stahl 1.3974, wie oben beschrieben, eine Abstandstoleranz von 0.5 bis 1 .5 % der relevanten Dimension auswählen, noch bevorzugter zwischen 0.75 und 1.25%.

Also für ein solches System und für einen Durchmesser des Targets von 150 mm könnte man gemäss der vorliegenden Erfindung eine radiale Abstandstoleranz S/2 von 0.5 mm auswählen, was insgesamt eine Abstandstoleranz S von 1 mm im Durchmesser bedeutet, die ca. 0.7% entspricht. Vorzugsweise ist die radiale Abstandstoleranz S/2 in diesem Zusammenhang zwischen 0.1 mm und 5 mm, noch mehr bevorzugt ist S/2 zwischen 0.3 mm und 1 mm, und besonders bevorzugt ist S/2 von etwa 0.5 mm.

Wenn das Target mit Führungsausformungen erfindungsgemäss versehen ist, sind die Führungsausformungen vorzugsweise aus dem gleichen Material, aus dem das Target angefertigt ist.

Wenn der Haltering mit Führungsausformungen erfindungsgemäss versehen ist, sind die Führungsausformungen vorzugsweise aus dem gleichen Material, aus dem der Haltering angefertigt ist.

Gemäss einer bevorzugten Variante der vorliegenden Erfindung ist die Frontseite-Fläche des Targets nicht flach.

Gemäss einer weiteren bevorzugten Variante der vorliegenden Erfindung ist die Frontseite-Fläche des Targets grösser als die Rückseite-Fläche des Targets.

Offenbart wurde eine Beschichtungsquelle als Materiallieferant für eine PVD Beschichtung, umfassend
a) eine in einer Halterung gelagerte Platte mit Plattenvorderseite und Plattenrückseite und mit Mitteln zur Zentrierung, wobei die Plattenvorderseite dafür vorgesehen ist, während des PVD-Prozesses von der Oberfläche aus Schichtmaterial in die Gasphase zu überführen, und die Mittel zur Zentrierung so ausgestaltet sind, dass die Zentrierung bei unterschiedlichen Plattentemperaturen gewährleistet ist
b) eine an der Plattenrückseite vorgesehene Kühlvorrichtung mit geschlossener Kühlplatte, die als bewegliche Membran ausgestaltet ist, wobei zur Gewährleistung eines guten Wärmekontaktes zwischen Plattenrückseite und Membran auf die Plattenrückseite eine selbstklebende Graphitfolie geklebt ist,
wobei an der Halterung und an der Kühlvorrichtung die Elemente eines Bajonettverschlusses vorgesehen sind, so dass sich die Halterung mit zentrierter Platte an die Kühlvorrichtung mittels des Bajonettverschlusses fixieren lässt.

Bei der Beschichtungsquelle kann das Material der Platte einen ersten thermischen Expansionskoeffizienten α1 aufweisen und das Material der Halterung einen zweiten thermischen Expansionskoeffizienten α2 aufweisen, wobei gilt: α1>α2.

Bei der Beschichtungsquelle kann die Halterung im Randbereich der Plattenrückseite eine Auflage zur flächigen Lagerung der Platte umfassen und die Halterung oberhalb der Plattenvorderseite eine Rille umfassen, so dass nach Einlegen der Platte in die Halterung diese dort mittels eines Spannringes, welcher in die Rille einrastet, fixiert werden kann.

Bei der Beschichtungsquelle kann die Halterung aus einem zähen, temperaturstabilen, unmagnetischen Stahl angefertigt sein, vorzugsweise aus Stahl 1.3974, welcher geschmiedet und bei 1020°C für eine Stunde lösungsgeglüht ist.

An der Beschichtungsquelle können Mittel zum Anschluss einer Spannungsquelle vorgesehen sein, die es ermöglichen, das Target gegenüber einer Elektrode auf negatives Potential zu legen, so dass das Target als Kathode verwendet und die Elektrode als Anode verwendet werden kann.

Die Anode kann um das Target herum platziert sein und als Anodenring ausgestaltet sein.

Es wurde eine PVD-Anlage mit zumindest einer wie oben beschriebenen Beschichtungsquelle offenbart.

## Patentansprüche

1. Beschichtungsquelle als Materiallieferant für eine PVD Beschichtung, umfassend
a) eine Halterung und eine in der Halterung gelagerte Platte mit Plattenvorderseite (1a) und Plattenrückseite (1c) und mit Mittel zur Zentrierung, wobei die Halterung eine rahmenförmige Plattenfassung (2) zur Aufnahme der Platte (1) umfasst, die Platte (1) ein Target ist und die Plattenvorderseite (1a) dafür vorgesehen ist während des PVD-Prozesses von der Oberfläche aus Schichtmaterial in die Gasphase zu überführen und die Mittel zur Zentrierung so ausgestaltet sind, dass die Zentrierung bei unterschiedlichen Plattentemperaturen gewährleistet ist
b) eine an der Plattenrückseite (1c) vorgesehene Kühlvorrichtung mit einem Kühlkanal (5) und mit geschlossener Kühlplatte die als bewegliche Membran ausgestaltet ist wobei zur Gewährleistung eines guten Wärmekontaktes zwischen Plattenrückseite (1c) und Membran auf die Plattenrückseite (1c) eine selbstklebende Graphitfolie geklebt ist
wobei an der Halterung und an der Kühlvorrichtung die Elemente eines Bajonettverschlusses vorgesehen sind so dass sich die Halterung mit zentrierter Platte an die Kühlvorrichtung mittels des Bajonettverschlusses fixieren lässt, wobei:
• zur Halterung des Targets (1) wenigstens drei zueinander beabtandetete Führungsausformungen (1f, 2f) und/oder Nuten (1n, 2n) jeweils im Target (1) und in der Targetfassung (2) vorhanden sind, wobei die Führungsausformungen (1f, 2f) des Targets (1) und/oder der Targetfassung (2) mit den Nuten (1n, 2n) der Targetfassung (2) und/oder des Targets (1) Paare "Führungsausformung-Nut" bilden, damit jeweils die Führungsausformungen (1f, 2f) des Targets (1) und/oder der Targetfassung (2) in den entsprechenden Nuten (1n, 2n) der Targetfassung (2) und/oder des Targets (1) gefasst werden, wenn das Target (1) auf die Targetfassung (2) gebracht wird,
• die Paare "Führungsausformung-Nut" (1f, 1n; 2f, 2n) derart verteilt sind, dass bei jedem Paar "Führungsausformung-Nut" (1f, 1n; 2f, 2n) die Position der Mitte der Breite der Nut (1n, 2n) mit der Position der Mitte der Breite der entsprechenden Führungsausformung (1f, 2f) übereinstimmt, und diese Position derart ausgewählt ist, dass sie sich bei Raumtemperatur in einer axialen Richtung vom Targetzentrum befindet, die nach einer Wärmeausdehnung des Targets (1) und/oder der Targetfassung (2) bei höheren Temperaturen in der gleichen axialen Richtung vom Targetzentrum unverändert bleibt,
• das Material der Platte (1) einen ersten thermische Expansionskoeffizienten α1 aufweist und das Material der Halterung einen zweiten thermischen Expansionskoeffizienten α2 aufweist, wobei gilt: α1>α2.

2. Beschichtungsquelle nach Anspruch 1, **dadurch gekennzeichnet, dass** die Halterung im Randbereich der Plattenrückseite eine Auflage zur flächigen Lagerung der Platte umfasst und die Halterung oberhalb der Plattenvorderseite eine Rille umfasst so dass nach Einlegen der Platte in die Halterung diese dort mittels eines Spannringes, welcher in die Rille einrastet, fixiert werden kann.

3. Beschichtungsquelle nach einem der vorangehenden Ansprüche, wobei die Halterung aus einem zähen, temperaturstabilen, unmagnetischen Stahl angefertigt ist, vorzugsweise aus Stahl 1.3974 welcher geschmiedet und bei 1020°C für eine Stunde lösungsgeglüht ist.

4. Beschichtungsquelle nach einem der vorangehenden Ansprüche, wobei an der Beschichtungsquelle Mittel zum Anschluss einer Spannungsquelle vorgesehen sind die es ermöglichen das Target gegenüber einer Elektrode auf negatives Potential zu legen so dass das Target als Kathode verwendet und die Elektrode als Anode verwendet werden kann.

5. Beschichtungsquelle nach Anspruch 4, wobei die Anode um das Target herum platziert und als Anodenring ausgestaltet ist.

6. Beschichtungsquelle nach einem der vorangehenden Ansprüche, wobei die Beschichtungsquelle für Hochleistungsimpulsmagnetronsputtering geeignet ist.

7. PVD-Anlage mit zumindest einer Beschichtungsquelle gemäss einem der vorangehenden Ansprüche.

## Claims

1. A coating source as a material supply for a PVD coating, including
a) a holder and a plate supported in a holder, having a plate front (1a), a plate back (1c), and a centering means; the holder has a frame-shaped plate mount (2) for accommodating the plate (1), the plate (1) is a target, and the plate front (1a) is provided for converting coating material from the surface into the gas phase during the PVD process and the centering means is embodied so that the centering is assured at different plate temperatures
b) a cooling device, which is provided on the plate back (1c), is equipped with a cooling conduit (5) and a closed cooling plate that is embodied in the form of a movable diaphragm; in order to ensure a good thermal contact between the plate back (1c) and the diaphragm, a self-adhesive graphite film is glued to the plate back (1c);
the elements of a bayonet fitting are provided on the holder and the cooling device so that the holder with the centered plate can be affixed to the cooling device by means of the bayonet fitting, wherein:
• in order to hold the target (1), at least three guide protrusions (1f, 2f) and/or grooves (1n, 2n) spaced apart from one another are respectively provided in the target (1) and in the target mount (2); the guide protrusions (1f, 2f) of the target (1) and/or the target mount (2) form "guide protrusion/groove" pairs with the grooves (1n, 2n) of the target mount (2) and/or the target (1) so that the guide protrusions (1f, 2f) of the target (1) and/or target mount (2) are held in the corresponding grooves (1n, 2n) of the target mount (2) and/or target (1) when the target (1) is attached to the target mount (2),
• the "guide protrusion/groove" pairs (1f, 1n; 2f, 2n) are distributed so that in each "guide protrusion/groove" pair (1f, 1n; 2f, 2n), the position of the middle of the width of the groove (1n, 2n) coincides with the position of the middle of the width of the corresponding guide protrusion (1f, 2f) and this position is selected so that at room temperature, it is situated in an axial direction of the target center, and, after a thermal expansion of the target (1) and/or of the target mount (2) at higher temperatures, this position remains unchanged in the same axial direction of the target center,
• the material of the plate (1) has a first thermal expansion coefficient α1 and the material of the holder has a second thermal expansion coefficient α2, where: α1 > α2.

2. The coating source according to claim 1 **characterized in that** in the edge region of the plate back, the holder has an abutting piece for the flat support of the plate and above the plate front, the holder has a flute so that after the plate is inserted into the holder, it can be affixed there by means of a snap ring, which snaps into the flute.

3. The coating source according to one of the preceding claims, wherein the holder is made of a tough, temperature-stable, nonmagnetic steel, preferably 1.3974 steel, which is forged and solution annealed at 1020°C for one hour.

4. The coating source according to one of the preceding claims, wherein the coating source is provided with means for connecting to a voltage source, which make it possible to apply a negative potential to the target relative to an electrode so that the target can be used as a cathode and the electrode can be used as an anode.

5. The coating source according to claim 4, wherein the anode is placed around the target and is embodied in the form of an anode ring.

6. The coating source according to one of the preceding claims, wherein the coating source is suitable for high power pulsed magnetron sputtering.

7. A PVD system with at least one coating source according to one of the preceding claims.

## Revendications

1. Source de revêtement à titre de fournisseur de matériau pour un revêtement PVD, comportant
a) une monture et une plaque montée dans la monture et présentant une face avant (1a) et une face arrière (1c) et des moyens de centrage, la monture comprenant un encadrement de plaque (2) en forme de cadre pour loger la plaque (1), la plaque (1) étant une cible, et la face avant (1a) de la plaque étant prévue pour transférer du matériau de couche à partir de la surface vers la phase gazeuse pendant le processus PVD, et les moyens de centrage étant réalisés de manière à assurer le centrage à différentes températures de la plaque,
b) un dispositif de refroidissement prévu sur la face arrière (1c) de la plaque et comprenant un canal de refroidissement (5) et une plaque de refroidissement fermée réalisée sous forme de membrane mobile, et pour assurer un bon contact thermique entre la face arrière (1c) de la plaque et la membrane, une feuille de graphite autocollante est collée sur la face arrière (1c) de la plaque,
dans laquelle
les éléments d'une fermeture à baïonnette sont prévus sur la monture et sur le dispositif de refroidissement, de telle sorte que la monture se laisse fixer avec la plaque centrée sur le dispositif de refroidissement au moyen de la fermeture à baïonnette, et
• pour retenir la cible (1), au moins trois conformations de guidage (1f, 2f) et/ou des gorges (1n, 2n) écartées les unes des autres sont prévues respectivement dans la cible (1) et dans l'encadrement de cible (2), les conformations de guidage (1f, 2f) de la cible (1) et/ou de l'encadrement de cible (2) forment des appariements "conformation de guidage - gorge" avec les gorges (1n, 2n) de l'encadrement de cible (2) et/ou de la cible (1), pour encadrer respectivement les conformations de guidage (1f, 2f) de la cible (1) et/ou l'encadrement de cible (2) dans les gorges correspondantes (1n, 2n) de l'encadrement de cible (2) et/ou de la cible (1), lorsque la cible (1) est placée sur l'encadrement de cible (2),
• les appariements "conformation de guidage - gorge" (1f, 1n ; 2f, 2n) sont répartis de telle sorte que pour chaque appariement "conformation de guidage - gorge" (1f, 1n ; 2f, 2n) la position du milieu de la largeur de la gorge (1n, 2n) coïncide avec la position du milieu de la largeur de la conformation de guidage correspondante (1f, 2f), et cette position est choisie de telle sorte qu'à la température ambiante elle se trouve en direction axiale du centre de la cible qui reste inchangée dans la même direction axiale du centre de la cible après une dilatation thermique de la cible (1) et/ou de l'encadrement de cible (2) à des températures plus élevées,
• le matériau de la plaque (1) présente un premier coefficient d'expansion thermique α1 et le matériau de la monture présente un second coefficient d'expansion thermique α2, tels que α1 > α2.

2. Source de revêtement selon la revendication 1,
**caractérisée en ce que**
dans la zone de bord de la face arrière de la plaque, la monture comprend un support pour le montage surfacique de la plaque, et la monture présente une rainure au-dessus de la face avant de la plaque, de sorte qu'une fois la plaque posée dans la monture, celle-ci peut être fixée au moyen d'un anneau de serrage qui vient s'enclencher dans la rainure.

3. Source de revêtement selon l'une des revendications précédentes,
dans laquelle
la monture est fabriquée en un acier dur, thermostable, amagnétique, de préférence en acier 1.3974 qui est forgé et recuit par mise en solution à 1020 °C pendant une heure.

4. Source de revêtement selon l'une des revendications précédentes,
dans laquelle
des moyens pour brancher une source de tension sont prévus sur la source de revêtement, qui permettent de mettre la cible à un potentiel négatif par rapport à une électrode, de sorte que la cible peut être utilisée comme cathode et l'électrode peut être utilisée comme anode.

5. Source de revêtement selon la revendication 4,
dans laquelle
l'anode est placée tout autour de la cible et est réalisée sous forme d'anode annulaire.

6. Source de revêtement selon l'une des revendications précédentes, dans laquelle
la source de revêtement convient pour la pulvérisation cathodique par magnétron à haute puissance puisée.

7. Installation PVD comportant au moins une source de revêtement selon l'une des revendications précédentes.
